# EUROPEAN PATENT APPLICATION

(11) **EP 0 702 415 A1**
(43) Date of publication of application: **20.03.1996**
(21) Application number: 95114533.3
(22) Date of filing: 15.09.1995
(51) Int. Cl.: H01L 39/24

(54) **Oxide superconductor and method of manufacturing the same**

(30) Priority: 16.09.1994 JP 221772/94
(71) Applicant: INTERNATIONAL SUPERCONDUCTIVITY TECHNOLOGY CENTER, Tokyo 105 (JP); SUMITOMO ELECTRIC INDUSTRIES, LTD, Osaka-shi, Osaka-fu 541 (JP); KABUSHIKI KAISHA TOSHIBA, Kawasaki-shi, Kanagawa-ken 210, Tokyo (JP); MITSUBISHI DENKI KABUSHIKI KAISHA, Tokyo 100 (JP)
(72) Inventor: Usami, Ryo, c/o Int. Supercond. Techn. Center, Shinonome 1-chome, Koto-ku, Tokyo 135 (JP); Itoh, Makoto, c/o Int. Supercond. Techn. Center, Shinonome 1-chome, Koto-ku, Tokyo 135 (JP); Kubota, Hiroshi, c/o Int. Supercond. Techn. Center, Shinonome 1-chome, Koto-ku, Tokyo 135 (JP); Puzniak, Roman, c/o Int. Supercond. Techn. Center, Shinonome 1-chome, Koto-ku, Tokyo 135 (JP); Yamauchi, Hisao, c/o Int. Supercond. Techn. Center, Shinonome 1-chome, Koto-ku, Tokyo 135 (JP)
(74) Representative: Pellmann, Hans-Bernd, Dipl.-Ing.

(57) **Abstract**

Defects are generated in an oxide superconductor containing mercury by irradiation of ions. The defects thus generated function as pins having an effect of increasing a critical current of the oxide superconductor. The pins can be suitably introduced into the oxide superconductor by a method wherein protons being longer in an implanting depth than other ion seeds are irradiated to the oxide superconductor in such a dose as to give the optimum defect density. With this method, it becomes possible to significantly lower the rate of reduction of the critical current density of an oxide superconductor containing mercury depending on the applied magnetic field, and hence to increase the critical current thereof.

## Description

### BACKGROUND OF THE INVENTION

### Field of the Invention

The present invention relates to an oxide superconductor used as a current conductor such as a wire, coil and interconnect, and a method of manufacturing the oxide superconductor.

### Description of the Related Art

A mercury series oxide superconductor used as a current conductor must be high in its critical current, however, it is small in the pinning force, and accordingly it is required to be artificially introduced with pins causing the pinning effect. From such a viewpoint, as described in a publication "J. Schwartz, et al.; Phys., Rev. B, Vol. 48 (1993), pp. 9932", there has been proposed a technique in which pins are introduced into a mercury series oxide superconductor expressed by a chemical formula HgBa₂CuO_{4+y} (where y is an arbitral value) by irradiation of neutrons for improving its critical current density.

In this HgBa₂CuO_{4+y} (where y is an arbitral value), however, the critical temperature Tc is as low as 96 K, and thereby the critical current density at 77 K after irradiation of neutrons is too low to be practically usable. The above-described technique is also inconvenient in terms of the application because it requires a reactor or accelerator for irradiation of neutrons.

### SUMMARY OF THE INVENTION

An object of the present invention is to solve the above-described problems and to provide an oxide superconductor capable of attaining a high critical current density by introducing pins into the oxide superconductor without irradiation of neutrons, and a method of manufacturing the oxide superconductor.

According to the first aspect of the present invention, there is provided an oxide superconductor containing mercury and irradiated with ions.

According to the second aspect of the present invention, there is provided an oxide superconductor expressed by a chemical formula HgBa₂Ca₂Cu₃O_{8+δ}(0≦ δ ≦0.4), which is irradiated with protons.

According to the third aspect of the present invention, there is provided a method of manufacturing an oxide superconductor containing mercury comprising the step of irradiating ions to the oxide superconductor.

According to the fourth aspect of the present invention, there is provided a method of manufacturing an oxide superconductor expressed by a chemical formula HgBa₂Ca₂Cu₃O_{8+δ} (0≦ δ ≦0.4) comprising the step of irradiating protons as an ion seed to the oxide superconductor.

According to the fifth aspect of the present invention, there is provided a method of manufacturing an oxide superconductor expressed by a chemical formula HgBa₂Ca₂Cu₃O_{8+δ}(0≦ δ ≦0.4) comprising the step of irradiating protons to the oxide superconductor in a dose of from 10¹⁶cm⁻² to 10¹⁸cm⁻².

In the first aspect of the present invention, defects are introduced into an oxide superconductor containing mercury by irradiating ions thereto. The defects function as pins, to significantly increase the critical current density of the oxide superconductor.

In the second aspect of the present invention, the critical current density of an oxide superconductor expressed by a chemical formula HgBa₂Ca₂Cu₃O_{8+δ}(0≦ δ ≦0.4) is significantly increased by irradiating protons being longer in its implanting depth than other ion seeds to the oxide superconductor thereby introducing pins over the oxide superconductor.

In the third aspect of the present invention, pins can be introduced into an oxide superconductor containing mercury by a practically usable method of irradiating ions to the oxide superconductor using a simple ion implanting apparatus, differently from a method of irradiating neutrons which requires a large scale of apparatus such as a reactor or accelerator.

In the fourth aspect of the present invention, a high critical current density at 77 K can be obtained, in an oxide superconductor expressed by a chemical formula HgBa₂Ca₂Cu₃O_{8+δ}(0≦ δ ≦0.4) having a critical temperature Tc of 135 K, by introducing effective pins to the oxide superconductor through irradiation of protons.

In the fifth aspect of the present invention, the density of pins in an oxide superconductor expressed by a chemical formula Ba₂Ca₂Cu₃O_{8+δ}(0≦ δ ≦0.4) can be optimized and a high critical current density thereof can be thus obtained by specifying the dose of protons irradiated thereto in the range of from 10¹⁶cm⁻² to 10¹⁸cm⁻².

The above and further objects and novel features of the invention will more fully appear from the following detailed description when the same is read in connection with the accompanying drawing. It is to be expressly understood, however, that the drawing is for purpose of illustration only and is not intended as a definition of the limits of the invention.

### BRIEF DESCRIPTION OF THE DRAWING

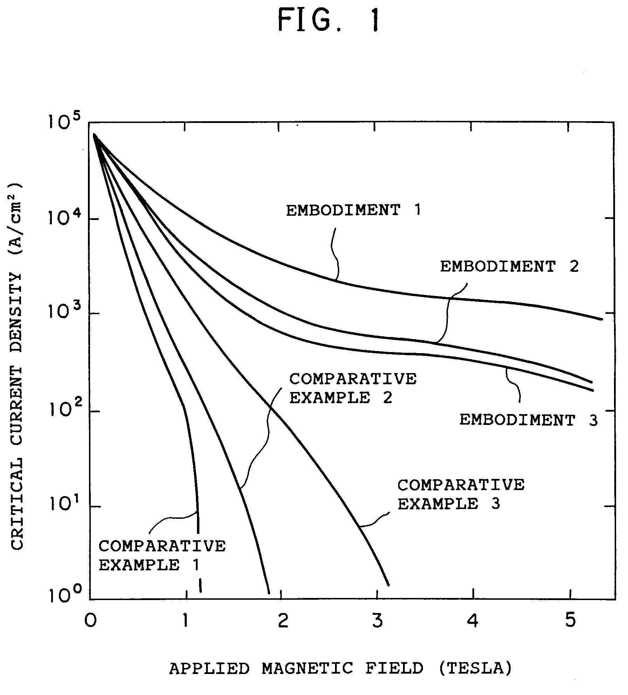

Fig. 1 is a graph showing the relationship between the critical current density measured at a temperature of 77 K and the applied magnetic field in parallel to the c-axis with respect to oxide superconductors expressed by a chemical formula HgBa₂Ca₂Cu₃O_{8+δ}(0≦ δ ≦0.4) manufactured in Embodiments 1 to 3 and Comparative Examples 1 to 3.

### DESCRIPTION OF THE PREFERRED EMBODIMENTS

The present inventors have studied the relationship between the critical current density and the applied magnetic field with respect to some oxide superconductors, HgBa₂Ca₂Cu₃O_{8+δ}(0≦ δ ≦0.4) which are irradiated with protons in different doses, and found the fact that the rate of reduction of the critical current density depending on the applied magnetic field is related to the dose of protons. Specifically, the implanted depth of a proton into a superconductor is largest among all ion seeds because the proton has the smallest mass among them, and accordingly it can be easily implanted into the whole superconductor thus easily introducing pins over the superconductor. In this case, when the dose of protons is lower than 10¹⁶cm⁻², the defect density caused by the irradiation of protons is low and thereby the defects do not effectively act as pins; whereas when it is more than 10¹⁸cm⁻², the superconductor is deteriorated by irradiation of protons, thus lowering the critical current density.

Hereinafter, the present invention will be more fully described by example of embodiments.

### Embodiment 1

Mercury oxide, barium oxide, calcium oxide and copper oxide were used as raw materials. These raw materials were mixed at a molar ratio of (HgO:BaO:CaO:CuO = 1:2:2:3), and compacted and molded. The green compact thus obtained was vacuum-sealed in a silica tube, and burned at 665°C for 100 hours, to thus synthesize a superconductor of a mercury series 1-2-2-3 phase. The superconductor was crushed and blended with resin, and then held in a magnetic field of 8 T for 12 hours for carrying out the c-axis orientation. After that, the superconductor was cut in parallel to the ab-face, and polished into a thickness of 0.07 mm. In this embodiment, the sample thus obtained was irradiated with protons in parallel to the c-axis in a dose of 5×10¹⁶cm⁻². The proton accelerating voltage was applied at 4 MeV for implanting protons into the whole sample having a thickness of 0.07 mm. The sample was examined in terms of the dependence of the magnetic field on the critical current density by applying to the sample a magnetic field in the range up to 5 tesla in parallel to the c-axis at a temperature of 77 K. The result is shown in Fig. 1. As is apparent from this figure, a reduction of the critical current density depending on the applied magnetic field in the range of from 1 to 2 tesla was low, and the critical current density at a magnetic field in the range of from 2 to 5 T was nearly constant irrespective of the applied magnetic field.

### Embodiment 2

Mercury oxide, barium oxide, calcium oxide and copper oxide were used as raw materials. These raw materials were mixed at a molar ratio of (HgO:BaO:CaO:CuO = 1:2:2:3), and compacted and molded. The green compact thus obtained was vacuum-sealed in a silica tube, and burned at 665°C for 100 hours, to thus synthesize a superconductor of a mercury series 1-2-2-3 phase. The superconductor was crushed and blended with resin, and then held in a magnetic field of 8 T for 12 hours for carrying out the c-axis orientation. After that, the superconductor was cut in parallel to the ab-face, and polished into a thickness of 0.06 mm. In this embodiment, the sample thus obtained was irradiated with protons in parallel to the c-axis in a dose of 1×10¹⁸cm⁻². The proton accelerating voltage was applied at 3.5 MeV for implanting protons into the whole sample having a thickness of 0.06 mm. The sample was examined in terms of the dependence of the magnetic field on the critical current density by applying to the sample a magnetic field in the range up to 5 tesla in parallel to the c-axis at a temperature of 77 K. The result is shown in Fig. 1. As is apparent from this figure, a reduction of the critical current density depending on the applied magnetic field in the range of from 1 to 2 tesla was low, and the critical current density at a magnetic field in the range of from 2 to 5 T was nearly constant irrespective of the applied magnetic field.

### Embodiment 3

Mercury oxide, barium oxide, calcium oxide and copper oxide were used as raw materials. These raw materials were mixed at a molar ratio of (HgO:BaO:CaO:CuO = 1:2:2:3), and compacted and molded. The green compact thus obtained was vacuum-sealed in a silica tube, and burned at 655°C for 100 hours, to thus synthesize a superconductor of a mercury series 1-2-2-3 phase. The superconductor was crushed and blended with resin, and then held in a magnetic field of 8 T for 12 hours for carrying out the c-axis orientation. After that, the superconductor was cut in parallel to the ab-face, and polished into a thickness of 0.06 mm. In this embodiment, the sample thus obtained was irradiated with protons in parallel to the c-axis in a dose of 5×10¹⁷cm⁻². The proton accelerating voltage was applied at 3.5 MeV for implanting protons into the whole sample having a thickness of 0.06 mm. The sample was examined in terms of the dependence of the magnetic field on the critical current density by applying to the sample a magnetic field in the range up to 5 tesla in parallel to the c-axis at a temperature of 77 K. The result is shown in Fig. 1. As is apparent from this figure, a reduction of the critical current density depending on the applied magnetic field in the range of from 1 to 2 tesla was low, and the critical current density at a magnetic field in the range of from 2 to 5 T was nearly constant irrespective of the applied magnetic field.

### Comparative Example 1

A sample made of a c-axis oriented superconductor of a mercury series 1-2-2-3 phase was prepared in the same manner as in Embodiment 1, except that this sample was not irradiated with protons. The sample thus obtained-was examined in terms of the dependence of the magnetic field on the critical current density in the same manner as in Embodiment 1. The result is shown in Fig. 1. As is apparent from this figure, the critical current density was significantly reduced depending on the applied magnetic field. Consequently, in this example, a reduction of the critical current density depending on the applied magnetic field becomes very larger as compared with Embodiment 1.

### Comparative Example 2

Mercury oxide, barium oxide, calcium oxide and copper oxide were used as raw materials. These raw materials were mixed at a molar ratio of (HgO:BaO:CaO:CuO = 1:2:2:3), and compacted and molded. The green compact thus obtained was vacuum-sealed in a silica tube, and burned at 665°C for 100 hours, to thus synthesize a superconductor of a mercury series 1-2-2-3 phase. The superconductor was crushed and blended with resin, and then held in a magnetic field of 8 T for 12 hours for carrying out the c-axis orientation. After that, the superconductor was cut in parallel to the ab-face, and polished into a thickness of 0.07 mm. As an example comparative to the present invention, the sample thus obtained was irradiated with protons in parallel to the c-axis at a dose of 5×10¹⁵cm⁻². This dose of protons is less than the lower limit of the range specified in the present invention. The proton accelerating voltage was applied at 4 MeV for implanting protons into the whole sample having a thickness of 0.07 mm. The sample was examined in terms of the dependence of the magnetic field on the critical current density by applying to the sample a magnetic field in the range up to 5 tesla in parallel to the c-axis at a temperature of 77 K. The result is shown in Fig. 1. As is apparent from this figure, the critical current density was significantly reduced depending on the applied magnetic field.

### Comparative Example 3

Mercury oxide, barium oxide, calcium oxide and copper oxide were used as raw materials. These raw materials were mixed at a molar ratio of (HgO:BaO:CaO:CuO = 1:2:2:3), and compacted and molded. The green compact thus obtained was vacuum-sealed in a silica tube, and burned at 655°C for 100 hours, to thus synthesize a superconductor of a mercury series 1-2-2-3 phase. The superconductor was crushed and blended with resin, and then held in a magnetic field of 8 T for 12 hours for carrying out the c-axis orientation. After that, the superconductor was cut in parallel to the ab-face, and polished into a thickness of 0.07 mm. As an example comparative to the present invention, the sample thus obtained was irradiated with protons in parallel to the c-axis in a dose of 5×10¹⁸cm⁻². This dose of protons is more than the upper limit of the range specified in the present invention. The proton accelerating voltage was applied at 4 MeV for implanting protons into the whole sample having a thickness of 0.07 mm. The sample was examined in terms of the dependence of the magnetic field on the critical current density by applying to the sample a magnetic field in the range up to 5 tesla in parallel to the c-axis at a temperature of 77 K. The result is shown in Fig. 1. As is apparent from this figure, the critical current density was significantly reduced depending on the applied magnetic field.

As is apparent from these embodiments and comparative examples, in the oxide superconductor expressed by a chemical formula HgBa₂Ca₂Cu₃O_{8+y} (where y is an arbitral value) irradiated with protons at an accelerating voltage being large enough to implant protons into the whole sample in a dose of from 10¹⁶cm⁻² to 10¹⁸cm⁻², the rate of reduction of the critical current density depending on the magnetic field applied to the oxide superconductor in parallel to the c-axis thereof was significantly reduced. The effect of the dose exerted on the rate of reduction of the critical current density depending on the magnetic field has been also known for an oxide superconductor expressed by a chemical formula YBa₂Cu₃O₇ as described in a document "Apply. Phys. Lett, vol. 56 (1990), pp. 2681". The above-described dose of protons was thus proved to be most suitable for improving the critical current density. A current conductor manufactured using such an oxide superconductor expressed by a chemical formula HgBa₂Ca₂Cu₃O_{8+y} (where y is an arbitral value) irradiated with protons in such a dose is expected to exhibit in a high magnetic field a higher critical current density than that of the current conductor manufactured using the prior art oxide superconductor of HgBa₂Ca₂Cu₃O_{8+y} (where y is an arbitral value) not irradiated with protons. The specific examples of such mercury series oxide superconductors include HgBa₂CaCu₂O_{6+y} (where y is an arbitral value) and HgBa₂Cu₂O_{4+y} (where y is an arbitral value), other than HgBa₂Ca₂Cu₃O_{8+y} (where y is an arbitral value). These materials are considered to generate the similar defects to those in HgBa₂Ca₂Cu₃O_{8+y} (where y is an arbitral value) by iron irradiation, and therefore, they are expected to be improved in the critical current density just as in the embodiments of the present invention.

As described above, according to the first aspect of the present invention, the critical current density of an oxide superconductor containing mercury can be increased by introducing defects functioning as pins into the oxide superconductor through irradiation of ions.

According to the second aspect of the present invention, since the irradiated ion seeds are protons which have longer implanted depths, pins are introduced over the oxide superconductor, so that the critical current density of an oxide superconductor expressed by a chemical formula HgBa₂Ca₂Cu₃O_{8+δ}(0≦ δ ≦0.4) can be significantly increased.

According to the third aspect of the present invention, ions are irradiated by the use of a simple ion implanting apparatus, so that pins are introduced into the oxide superconductor by a practically usable method of irradiating ions, resulting in the effect that the critical current density of an oxide superconductor containing mercury can be increased.

According to the fourth aspect of the present invention, by irradiating ions to an oxide superconductor of HgBa₂Ca₂Cu₃O_{8+δ}(0≦ δ ≦0.4) having a critical temperature Tc of 135 K, effective pins are introduced into the oxide superconductor so that a high critical current density at 77 K can be obtained.

According to the fifth aspect of the present invention, the density of pins in an oxide superconductor of HgBa₂Ca₂Cu₃O_{8+δ}(0≦ δ ≦0.4) can be optimized and the high critical current density thereof can be thus obtained by specifying the dose of protons irradiated thereto in the range of from 10¹⁶cm⁻² to 10¹⁸cm⁻².

Defects are generated in an oxide superconductor containing mercury by irradiation of ions. The defects thus generated function as pins having an effect of increasing a critical current of the oxide superconductor. The pins can be suitably introduced into the oxide superconductor by a method wherein protons being longer in an implanting depth than other ion seeds are irradiated to the oxide superconductor in such a dose as to give the optimum defect density. With this method, it becomes possible to significantly lower the rate of reduction of the critical current density of an oxide superconductor containing mercury depending on the applied magnetic field, and hence to increase the critical current thereof.

## Claims

1. An oxide superconductor, containing mercury, wherein ions are irradiated to said oxide superconductor.

2. An oxide superconductor according to claim 1, wherein said ions comprise protons, and said oxide superconductor containing mercury is expressed by a chemical formula HgBa₂Ca₂Cu₃O_{8+δ}(0≦ δ ≦0.4).

3. A method of manufacturing an oxide superconductor comprising the step of irradiating ions to an oxide superconductor containing mercury.

4. A method of manufacturing an oxide superconductor according to claim 3, said ions comprise protons, and said oxide superconductor containing mercury is expressed by a chemical formula HgBa₂Ca₂Cu₃O_{8+δ}(0≦ δ ≦0.4).

5. A method of manufacturing an oxide superconductor according to claim 4, wherein said protons are irradiated in a dose of from 10¹⁶cm⁻² to 10¹⁸cm⁻².
